# EUROPEAN PATENT SPECIFICATION

(11) **EP 4 380 045 B1**
(45) Date of publication and mention of the grant of the patent: **27.08.2025**
(21) Application number: 23833293.6
(22) Date of filing: 07.09.2023
(51) Int. Cl.: H03F 1/30, H03G 3/00, H03F 1/02, H03F 3/187, H03F 3/217, H04R 3/00

(54) **AUDIO AMPLIFICATION CIRCUIT, BOARD CARD, AND ELECTRONIC DEVICE**
AUDIOVERSTÄRKUNGSSCHALTUNG, PLATINENKARTE UND ELEKTRONISCHE VORRICHTUNG
CIRCUIT D'AMPLIFICATION AUDIO, CARTE DE CIRCUIT IMPRIMÉ ET DISPOSITIF ÉLECTRONIQUE

(30) Priority: 21.10.2022 CN 202211290255
(43) Date of publication of application: 05.06.2024
(73) Proprietor: Honor Device Co., Ltd., Shenzhen, Guangdong 518040 (CN)
(72) Inventor: ZHU, Chen, Shenzhen, Guangdong 518040 (CN); ZHANG, Chengxu, Shenzhen, Guangdong 518040 (CN)
(74) Representative: Beder, Jens
(86) International application number: PCT/CN2023/117502
(87) International publication number: WO 2024/082862

(56) References cited:
- EP-A2- 1 282 340
- EP-B1- 3 332 472
- CN-A- 113 676 140
- CN-A- 115 378 370
- CN-U- 206 878 780
- US-A1- 2015 349 737
- US-A1- 2017 142 518
- US-A1- 2017 294 888
- US-A1- 2018 337 637
- US-A1- 2020 106 393
- US-A1- 2020 106 393

## Description

This application claims priority to Chinese Patent Application CN 115 378 370 A (Application No. 202211290255.7), entitled "AUDIO AMPLIFICATION CIRCUIT, BOARD, AND ELECTRONIC DEVICE" and filed with the China National Intellectual Property Administration on October 21, 2022.

### TECHNICAL FIELD

This application relates to the field of electronic technologies, and in particular, to an audio amplification circuit, a board, and an electronic device.

### BACKGROUND

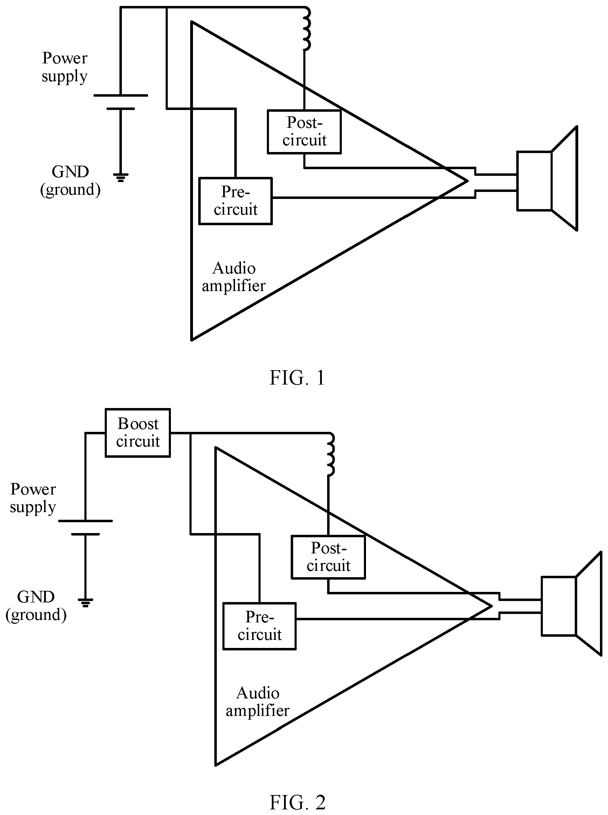

In an existing mobile phone system, as shown in FIG. 1, a power supply voltage of an audio amplifier (for example, an audio SmartPA) is usually directly provided by a battery. When battery power is reduced, the power supply voltage drops. When the power supply voltage drops below a UVLO (under voltage lock out, Under Voltage Lock Out) voltage of the audio amplifier, the audio amplifier is reset, and consequently, reliability of the audio amplifier is reduced. To ensure that the audio amplifier can still stably work at a low voltage, in the related art, a boost circuit is connected in series with a power supply end. The boost circuit connected in series with the power supply end is additionally added, to increase a voltage value of an input voltage of the audio amplifier, for example, as shown in FIG. 2. In this manner, although the audio amplifier can work at the low voltage, a relatively large power loss may be additionally caused.

EP 3 332 472 B1 relates to circuits concerning or relating to dynamically limiting the peak current consumption of a switching direct-current to direct-current (DC-DC) boost converter based on power supply conditions, triggering various user configurable or dynamic thresholds which result in a managed change of the switching converter's peak current limiting with the purpose of dynamically restricting peak power supply consumption from the boost converter's supply.

US 2020/106393 A1 discloses an amplifier power converter input current/power limit adjustment using amplifier load determinations.

US 2015/349737 A1 discloses a method and apparatus for amplifying audio signals without exceeding an input current limit budgeted for the audio power amplifier circuit includes an intermediate energy storage between a battery and the audio power amplifier which provides an energy reserve to support amplifying peaks where the peaks have a peak power that is greater than the power that can be drawn from the battery due to the input current limit.

US 2017/142518 A1 discloses a method for prevention of signal clipping due to decrease in amplifier supply voltage.

EP 1 282 340 A2 discloses a system and method for reducing hearing aid squeal.

### SUMMARY

To solve the problem of reducing a power loss, embodiments of this application provide an audio amplification circuit, a board, and an electronic device according to the enclosed independent claims. Advantageous features of the present invention are defined in the corresponding subclaims. In the following, parts of the description and drawings referring to embodiments, which are not covered by the claims, are not presented as embodiments of the invention but as examples useful for understanding the invention.

According to a first aspect of an embodiment of this application, an audio amplification circuit is provided, including:
a boost module and an audio amplifier, where the audio amplifier includes a pre-module and a post-module; an input end of the boost module is connected to a power supply, an output end of the boost module is connected to an input end of the pre-module, and an input end of the post-module is connected to the power supply;
the boost module is configured to boost a first voltage signal when a voltage value of the received first voltage signal of the power supply is less than a first preset voltage value to obtain a second voltage signal whose voltage value is a second preset voltage value, and send the second voltage signal to the input end of the pre-module, where the second preset voltage value is not less than the first preset voltage value.

In a possible implementation, the pre-module includes a pre-amplifier and a controller, and the post-module includes a first Boost.

In a possible implementation, the boost module is a System Boost, and the System Boost is a native boost module on a board on which the audio amplifier is located.

In a possible implementation, the boost module is a second Boost.

In a possible implementation, the boost module is a Boost Bypass.

In a possible implementation, the audio amplification circuit further includes:
a voltage determining module, configured to detect the voltage value of the first voltage signal of the power supply, and send a reset instruction to the controller when the voltage value of the first voltage signal is less than a third preset voltage value, where the third preset voltage value is less than the first preset voltage value; and
the controller is configured to reset the audio amplifier in response to receiving the reset instruction.

In a possible implementation, the voltage determining module includes:
a voltage measurement submodule and a system on chip, where
the voltage measurement submodule is respectively connected to the power supply and the system on chip, and the system on chip is connected to the controller;
the voltage measurement submodule is configured to detect the voltage value of the first voltage signal of the power supply, and send the voltage value of the first voltage signal to the system on chip; and
the system on chip is configured to compare the received voltage value of the first voltage signal with the third preset voltage value, and send the reset instruction to the controller when the received voltage value of the first voltage signal is less than the third preset voltage value.

In a possible implementation, the voltage measurement submodule is a power management unit or a voltameter, and both the voltage measurement submodule and the system on chip are native devices on a board on which the audio amplifier is located.

According to a second aspect of an embodiment of this application, a board is provided, including:
the audio amplification circuit according to any implementation of the first aspect.

According to a third aspect of an embodiment of this application, an electronic device is provided, including:
the board according to the second aspect.

Embodiments of this application have the following beneficial effects:
Provided in embodiments of this application are an audio amplification circuit, a board, and an electronic device. The circuit includes: a boost module and an audio amplifier, where the audio amplifier includes a pre-module and a post-module; an input end of the boost module is connected to a power supply, an output end of the boost module is connected to an input end of the pre-module, and an input end of the post-module is connected to the power supply; the boost module is configured to boost a first voltage signal when a voltage value of the received first voltage signal of the power supply is less than a first preset voltage value to obtain a second voltage signal whose voltage value is a second preset voltage value, and send the second voltage signal to the input end of the pre-module, where the second preset voltage value is not less than the first preset voltage value. In the audio amplification circuit provided in this application, a high-power channel and a low-power channel of the audio amplifier are separated in a dual-rail power supply manner. After the boost module boosts the first voltage signal of the power supply, the pre-module (the low-power channel) is powered, and the post-module (the high-power channel) is still powered by the power supply. In this way, it can be ensured that when the voltage value of the power supply drops below the first preset voltage value, the audio amplifier can still work stably, and compared with the related art in which the boost module is directly connected in series between the power supply and the audio amplifier, a current flowing through the boost module can be reduced, so that a power loss generated by the boost module is also relatively small. Therefore, by using the audio amplification circuit provided in this application, the power loss is reduced.

Certainly, any product or method for implementing this application does not necessarily need to simultaneously achieve all the advantages described above.

### BRIEF DESCRIPTION OF DRAWINGS

The accompanying drawings described herein are used for providing a further understanding of this application, and form part of this application. Exemplary embodiments of this application and descriptions thereof are used for explaining this application, and do not constitute any inappropriate limitation to this application.
FIG. 1 is a schematic diagram of a power supply manner of an audio amplifier in the related art;
FIG. 2 is a schematic diagram of connecting a power supply to a boost circuit in series to supply power in the related art;
FIG. 3 is a first schematic diagram of an audio amplification circuit according to an embodiment of this application;
FIG. 4 is a second schematic diagram of an audio amplification circuit according to an embodiment that does not relate to the subject matter of the enclosed claims;
FIG. 5 is a third schematic diagram of an audio amplification circuit according to an embodiment of this application;
FIG. 6 is a fourth schematic diagram of an audio amplification circuit according to an embodiment of this application;
FIG. 7 is a fifth schematic diagram of an audio amplification circuit according to an embodiment of this application; and
FIG. 8 is a schematic flowchart of gain adjustment and reset protection of an audio amplification circuit according to an embodiment of this application.

### DESCRIPTION OF EMBODIMENTS

To make the objectives, technical solutions, and advantages of the present invention clearer and more comprehensible, the following further describes the present invention with reference to the accompanying drawings and embodiments. Apparently, the described embodiments are merely some but not all of embodiments of the present invention. All other embodiments obtained by a person of ordinary skill in the art based on embodiments of the present invention shall fall within the protection scope of the present invention.

First, a power supply problem existing in a current audio amplifier is simply described.

As shown in FIG. 1, a first end of a power supply is grounded (GND), and a second end of the power supply is respectively connected to a pre-circuit and a post-circuit of the audio amplifier.

The audio amplifier is directly powered by the power supply. The audio amplifier is reset when a voltage signal of the power supply drops below UVLO (under voltage lock out, under voltage lock out) of the audio amplifier, and consequently, the audio amplifier cannot stably work.

In the related art, a voltage value of an input voltage of the audio amplifier is increased by directly connecting a boost circuit (Buck Boost or Boost Bypass) in series with the power supply, to ensure stable work of the audio amplifier, as shown in FIG. 2. However, when such a manner is used, a current flowing through the boost circuit is relatively large, and a power loss generated by the boost circuit is also relatively large.

The Buck Boost circuit or the Boost Bypass circuit are simply described below. The Buck Boost is a buck-boost circuit and is configured to increase the voltage value of the input voltage of the audio amplifier. The Boost Bypass is a boost circuit with a Bypass function. The Bypass is a bypass channel. The Bypass literally means adding a channel aside for bypassing. In fact, an input is allowed to directly pass through the channel, so that the audio amplifier is directly powered by using a voltage of the power supply greater than the UVLO of the audio amplifier. However, when the voltage of the power supply is lower than the UVLO of the audio amplifier, the Boost (the boost circuit) works to increase the voltage to a state in which the audio amplifier can work.

To reduce the power loss, embodiments of this application provide an audio amplification circuit, a board, and an electronic device.

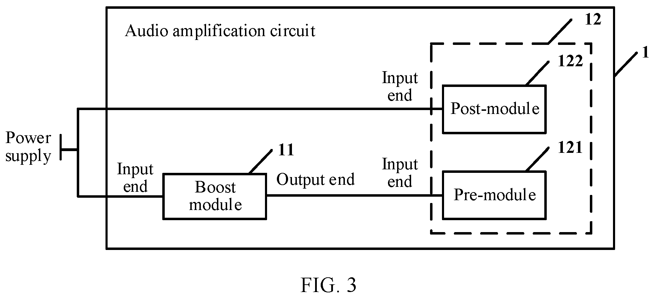

An audio amplification circuit 1 provided in an embodiment of this application is described in detail below. Referring to FIG. 3, the circuit includes:
a boost module 11 and an audio amplifier 12, where the audio amplifier 12 includes a pre-module 121 and a post-module 122; an input end of the boost module 11 is connected to a power supply, an output end of the boost module 11 is connected to an input end of the pre-module 121, and an input end of the post-module 122 is connected to the power supply;
the boost module 11 is configured to boost a first voltage signal when a voltage value of the received first voltage signal of the power supply is less than a first preset voltage value to obtain a second voltage signal whose voltage value is a second preset voltage value, and send the second voltage signal to the input end of the pre-module 121, where the second preset voltage value is not less than the first preset voltage value.

The power supply may be a battery or a charging and discharging management chip, which is not specifically limited in this application. In an example, the power supply is the battery, which supplies power to the boost module and the post-module. When battery power is reduced, the voltage value of the first voltage signal is less than the first preset voltage value.

The first preset voltage value is a voltage value corresponding to UVLO (under voltage lock out) of the audio amplifier. The under voltage lock out of the audio amplifier means that when an input voltage of the audio amplifier is less than a value (which refers to the first preset voltage value herein), the pre-module of the audio amplifier cannot meet a working condition, and consequently, the audio amplifier does not work and is in a protection state. A specific value of the first preset voltage value is related to a design of the audio amplification circuit and model selection of the audio amplifier and the like, and a specific value of the second preset voltage value is not less than the first preset voltage value, to ensure that a boosted voltage signal enables the pre-module to stably work. For example, the first preset voltage value may be set to 3 V, the pre-module can stably work between 3 V and 5 V, and the second preset voltage value may be set to a voltage value between 3 V and 5 V.

In an example, when the voltage value of the first voltage signal of the power supply drops to 2.5 V, the boost module boosts the first voltage signal to obtain a second voltage signal with a voltage value of 4 V, and sends the second voltage signal to the input end of the pre-module, to ensure that the pre-module meets the working condition, thereby ensuring that the audio amplifier stably works.

The post-module is a high-power channel of the audio amplifier, and the pre-module is a low-power channel of the audio amplifier. Power supplies of the high-power channel and the low-power channel of the audio amplifier are separated (dual-rail power supply). The boost module supplies power to the pre-module after boosting the first voltage signal of the power supply, and the post-module is still powered by the power supply. In this way, it can be ensured that, when a voltage value of the power supply drops below the first preset voltage value, the pre-module of the audio amplifier can stably work, a power loss generated by the boost module is also relatively small, and the post-module is still powered by the power supply, so that power output efficiency is ensured, and the audio amplifier achieves balance between high power output efficiency and a low working voltage.

The audio amplifier may be classified into class A, class B, class AB, and class D amplifiers. In an example, the audio amplifier is a SmartPA (which is the class D amplifier for audio amplification).

In a possible implementation, the pre-module 121 includes a pre-amplifier 1211 and a controller 1212, and the post-module 122 includes a first Boost 1221.

In a possible implementation, the boost module 11 is a System Boost, and the System Boost is a native boost module on a board on which the audio amplifier is located.

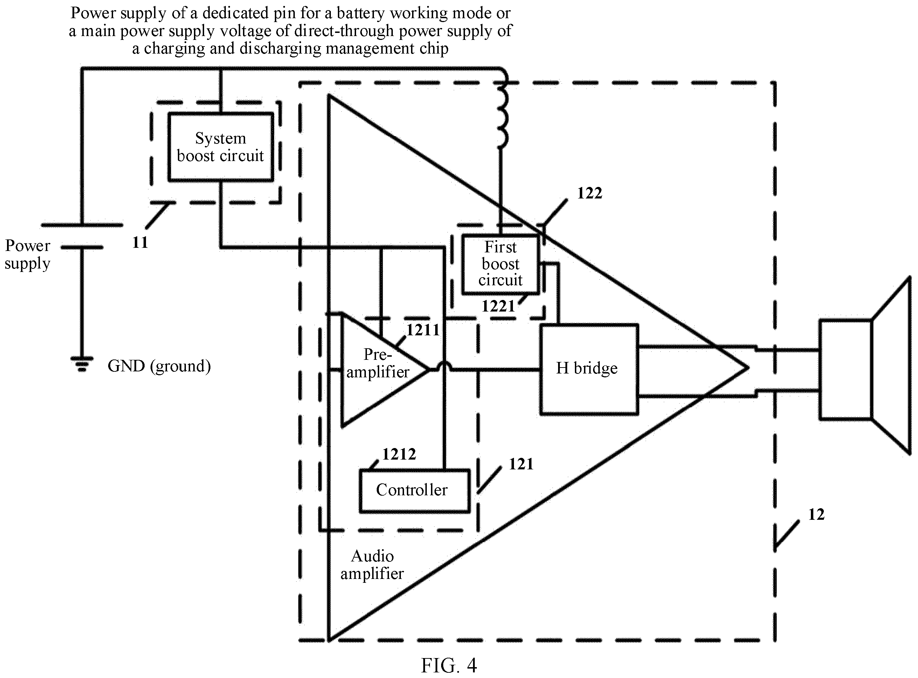

As shown in FIG. 4, English descriptions corresponding to relevant terms in FIG. 4 are first illustrated, Power supply of a dedicated pin for a battery working mode: VBAT; main power supply voltage of direct-through power supply of a charging and discharging management chip: VPH_PWR; boost circuit: Boost; control circuit (controller): Control; and H bridge: H Bridge, configured to convert a direct current signal into an alternating current signal.

A first end of the power supply is grounded (GND), and A second end of the power supply is respectively connected to an input end of the System Boost and an input end of the first Boost (a first boost circuit) 1221. An output end of the System Boost is respectively connected to input ends of the pre-amplifier 1211 and the controller 1212. An output end of the pre-amplifier 1211 is connected to a second input end of the H bridge, an output end of the first Boost 1221 is connected to a first input end of the H bridge (H Bridge), and an output end of the H bridge is connected to a speaker.

The pre-amplifier 1211 is configured to amplify the second voltage signal outputted by the System Boost, and the first Boost 1221 is configured to amplify a voltage signal transmitted by the power supply.

The speaker is configured to convert the alternating current signal into an acoustic signal.

The native boost module is described below by using an example. By using a mobile phone board as an example, in addition to an audio module, the mobile phone board further includes modules such as a display, a processor, and a radio frequency antenna. These modules also require a Boost, and a System Boost (a system boost circuit) is shared between a plurality of modules, to reduce an area of the board, and reduce costs.

In a possible implementation, the boost module 11 is a second Boost.

In a possible implementation, the boost module 11 is a Boost Bypass.

In an example, the boost module may be a System Boost, a Boost, or a Boost Bypass. The Boost Bypass is a boost with a Bypass function, and the Bypass is a bypass channel.

In this embodiment of this application, a high-power channel and a low-power channel of the audio amplifier are separated in a dual-rail power supply manner. After the boost module boosts the first voltage signal of the power supply, the pre-module (the low-power channel) is powered, and the post-module (the high-power channel) is still powered by the power supply. In this way, it can be ensured that when the voltage value of the power supply drops below the first preset voltage value, the audio amplifier can still work stably, and compared with the related art in which the boost module is directly connected in series between the power supply and the audio amplifier, a current flowing through the boost module may be reduced, so that a power loss on the boost module is also relatively small. Therefore, the power loss is reduced.

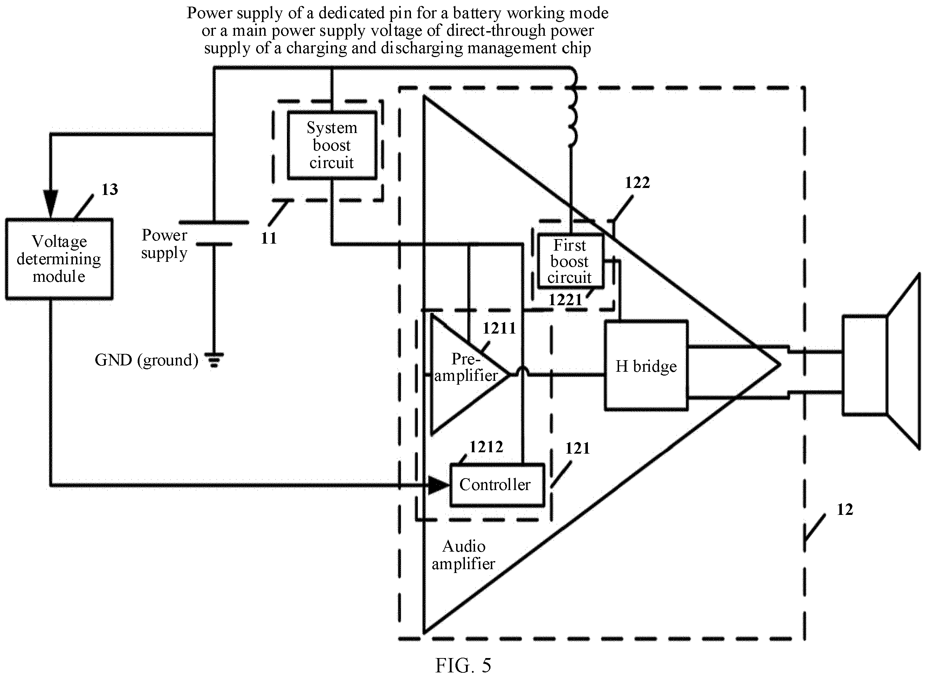

In a possible implementation, referring to FIG. 5, the audio amplification circuit 1 further includes:
a voltage determining module 13, configured to detect the voltage value of the first voltage signal of the power supply, and send a reset instruction to the controller 1212 when the voltage value of the first voltage signal is less than a third preset voltage value, where the third preset voltage value is less than the first preset voltage value; and
the controller 1212, configured to reset the audio amplifier 12 in response to receiving the reset instruction.

An input end of the voltage determining module 13 is connected to the power supply, and an output end of the voltage determining module 13 is connected to the controller 1212.

In the audio amplification circuit in this application, a power supply pin of the audio amplifier cannot detect a voltage of the power supply. In view of this, the voltage determining module is added to detect the voltage value of the first voltage signal of the power supply, and send the reset instruction to the controller when the voltage value of the first voltage signal is less than the third preset voltage value.

The third preset voltage value is a corresponding voltage value when the voltage of the power supply is low, and a specific value is less than the first preset voltage value. For example, when the first preset voltage value is 3 V, a value range of the third preset voltage value may be set to 0 V to 2 V. In an example, the third preset voltage value may be set to 0.5 V.

Sending the reset instruction to the controller means that the voltage determining module detects that the voltage value of the first voltage signal is less than the third preset voltage value. In this case, the audio amplifier needs to be protected, and the voltage determining module delivers the reset instruction to the controller to actively protect the audio amplifier. The controller receives the reset instruction and resets the audio amplifier.

In this embodiment of this application, when detecting that the voltage value of the first voltage signal of the power supply is less than the third preset voltage value, the voltage determining module sends the reset instruction to the controller, and after receiving the reset instruction, the controller resets the audio amplifier. In this way, the audio amplifier is protected.

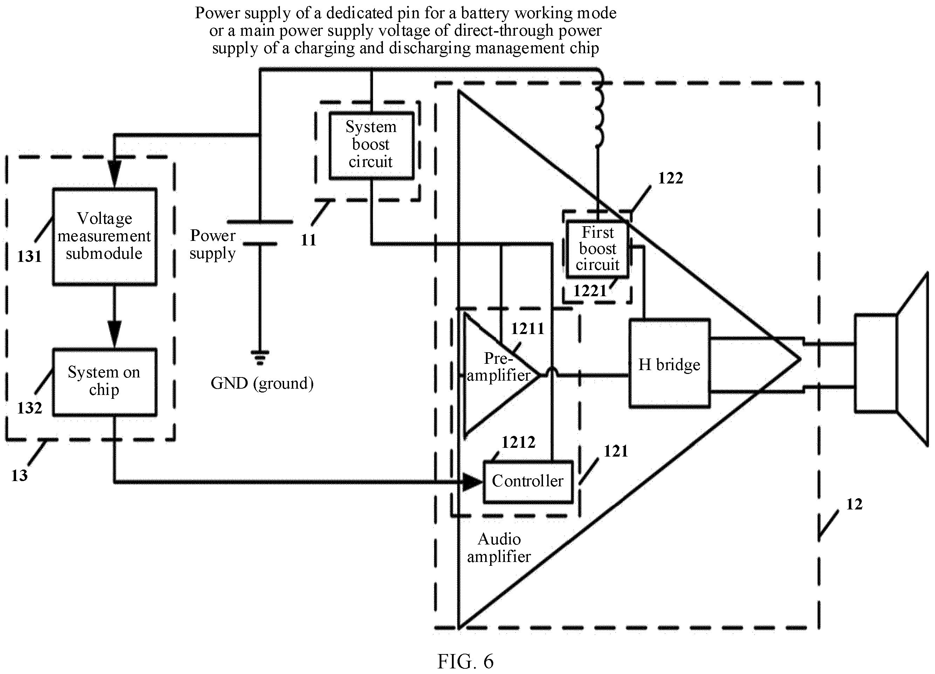

In a possible implementation, referring to FIG. 6, the voltage determining module 13 includes:
a voltage measurement submodule 131 and a system on chip 132, where
the voltage measurement submodule 131 is respectively connected to the power supply and the system on chip 132, and the system on chip 132 is connected to the controller 1212;
the voltage measurement submodule 131 is configured to detect the voltage value of the first voltage signal of the power supply, and send the voltage value of the first voltage signal to the system on chip 132; and
the system on chip 132 is configured to compare the received voltage value of the first voltage signal with the third preset voltage value, and send the reset instruction to the controller 1212 when the received voltage value of the first voltage signal is less than the third preset voltage value.

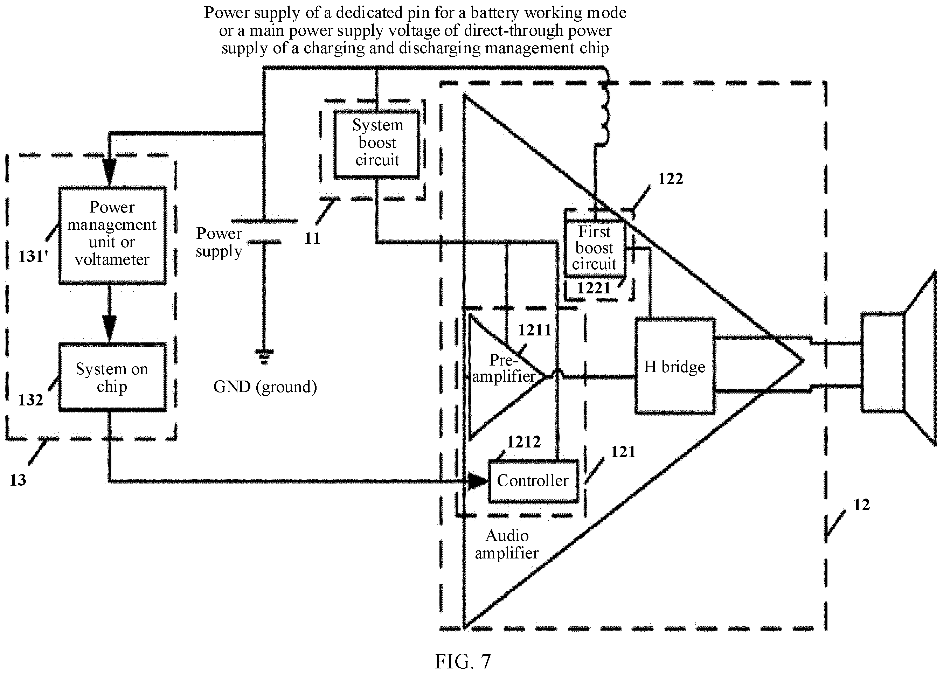

In a possible implementation, referring to FIG. 7, the voltage measurement submodule 131' is a power management unit or a voltameter, and both the voltage measurement submodule 131' and the system on chip 132 are native devices on a board on which the audio amplifier 12 is located.

In the audio amplification circuit in this application, a power supply pin of the audio amplifier cannot detect a voltage of the power supply. In view of this, the voltage measurement submodule is added to detect the voltage value of the first voltage signal of the power supply, and send the voltage value of the first voltage signal to the system on chip (SOC). The system on chip compares the received voltage value of the first voltage signal with the third preset voltage value, and sends the reset instruction to the controller when the received voltage value of the first voltage signal is less than the third preset voltage value.

The native device is described below by using an example. By using a mobile phone board as an example, the system on chip (SOC) is not a newly added device. A processor in the mobile phone board may be reused, and an effect such as sending a reset instruction to the controller is implemented only by adding a program. Similarly, the voltage measurement submodule is a reused device in the mobile phone board.

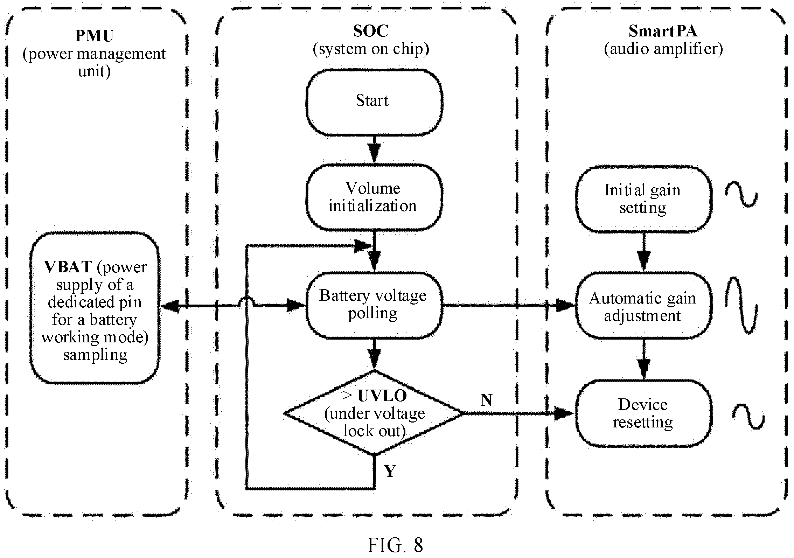

In an example, as shown in FIG. 8, a PMU (Power Management Unit, power management unit) performs VBAT sampling (where the power supply is a battery). After completing volume initialization on the SmartPA (the audio amplifier), the SOC starts to poll a battery voltage value sent by the PMU, and sends a polling result to the SmartPA. After setting an initial gain, the SmartPA adjusts a system gain corresponding to the battery voltage value by using an automatic gain to ensure that the SmartPA does not cause clipping distortion due to a low voltage. The SOC also performs low-voltage alarm judgment. When the battery voltage value is less than the third preset voltage value, the SmartPA is protectively reset. The above operations performed by the SmartPA are performed by a controller of the SmartPA.

Clipping distortion is described below by using an example. A voltage value of the power supply is 2.5 V, a gain (an amplification factor) of the SmartPA is 6, and a maximum signal of 1/2 V is inputted into the SmartPA. The SmartPA should output 6 times (3 V) of this signal to the speaker, but the signal of 3 V is not generated. This is because the power supply is only 2.5 V. As a result, top and bottom ends of the signal may cause distortion, which is clipping distortion. In this case, the SmartPA adjusts the gain through the controller, and reduces the gain, that is, reduces the amplification factor, so that a volume decreases accordingly to protect the SmartPA from causing clipping distortion.

In this embodiment of this application, when the voltage value of the first voltage signal of the power supply is less than the third preset voltage value, the system on chip sends the reset instruction to the controller, thereby achieving protection of the audio amplifier.

An embodiment of this application further provides a board. The board includes any audio amplification circuit described above.

The board may be a multimedia board or a sound card circuit board, which is not limited in this application.

An embodiment of this application further provides an electronic device. The electronic device includes the board described above.

The electronic device includes a mobile, a computer, and the like. This is not limited in this application.

It should be noted that the relational terms herein such as first and second are used only to differentiate an entity or operation from another entity or operation, and do not require or imply any actual relationship or sequence between these entities or operations. Moreover, the terms "include," "comprise," and any variation thereof are intended to cover a non-exclusive inclusion. Therefore, in the context of a process, a method, an object, or a device that includes a series of elements, the process, method, object, or device not only includes such elements, but also includes other elements not specified expressly, or may include inherent elements of the process, method, object, or device. Unless otherwise specified, an element limited by "include a/an..." does not exclude other same elements existing in the process, the method, the article, or the device that includes the element.

Embodiments of this specification are all described in a relevant manner, for same or similar parts in embodiments, refer to such embodiments, and descriptions of each embodiment focus on a difference from other embodiments. Especially, a system embodiment is basically similar to a method embodiment, and therefore is described briefly; for related parts, reference may be made to partial descriptions in the method embodiment.

## Claims

1. An audio amplification circuit (1), comprising:
a boost module (11), an audio amplifier (12) and a voltage determining module (13), wherein the audio amplifier (12) comprises a pre-module (121) and a post-module (122); the pre-module (121) comprises a pre-amplifier (1211) configured to pre-amplify an audio signal, a controller (1212) and an input end for powering up the pre-module (121), and the post-module (122) comprises an output stage configured to amplify the audio signal pre-amplified by the pre-amplifier (1211) and an input end for powering up the post-module (122); an input end of the boost module (11) is connected to a power supply to receive a first voltage signal from the power supply, an output end of the boost module (11) is connected to the input end of the pre-module (121), and the input end of the post-module (122) is connected to the power supply to receive the first voltage signal from the power supply; and
the boost module (11) is configured to boost the first voltage signal when a voltage value of the first voltage signal is less than a first preset voltage value to obtain a second voltage signal whose voltage value is a second preset voltage value, and send the second voltage signal to the input end of the pre-module (121), wherein the second preset voltage value is not less than the first preset voltage value; and
the voltage determining module (13) is configured to detect the voltage value of the first voltage signal, and send a reset instruction to the controller (1212) when the voltage value of the first voltage signal is less than a third preset voltage value, wherein the third preset voltage value is less than the first preset voltage value; and
the controller (1212), configured to reset the audio amplifier (12) in response to receiving the reset instruction.

2. The circuit according to claim 1, wherein the boost module (11) is a System Boost, and the System Boost is a native boost module on a board on which the audio amplifier (12) is located.

3. The circuit according to claim 1, wherein the boost module (11) is a second Boost.

4. The circuit according to claim 1, wherein the boost module (11) is a Boost Bypass.

5. The circuit according to claim 1 to 4, wherein the voltage determining module (13) comprises:
a voltage measurement submodule (131) and a system on chip (132), wherein
the voltage measurement submodule (131) is respectively connected to the power supply and the system on chip (132), and the system on chip (132) is connected to the controller (1212);
the voltage measurement submodule (131) is configured to detect the voltage value of the first voltage signal, and send the voltage value of the first voltage signal to the system on chip (132); and
the system on chip (132) is configured to compare the voltage value of the first voltage signal with the third preset voltage value, and send the reset instruction to the controller (1212) when the received voltage value of the first voltage signal is less than the third preset voltage value.

6. The circuit according to claim 5, wherein the voltage measurement submodule (131) is a power management unit or a voltameter, and both the voltage measurement submodule (131) and the system on chip (132) are native devices on a board on which the audio amplifier (12) is located.

7. A board, comprising:
the audio amplification circuit (1) according to any one of claims 1 to 6.

8. An electronic device, comprising:
the board according to claim 7.

## Patentansprüche

1. Eine Audioverstärkerschaltung (1), umfassend:
ein Boost-Modul (11), einen Audioverstärker (12) und ein Spannungsbestimmungsmodul (13), wobei der Audioverstärker (12) ein Vorstufenmodul (121) und ein Nachstufenmodul (122) umfasst; das Vorstufenmodul (121) umfasst einen Vorverstärker (1211), der so ausgelegt ist, ein Audiosignal vorzuverstärken, einen Controller (1212) sowie einen Eingang zur Stromversorgung des Vorstufenmoduls (121); das Nachstufenmodul (122) umfasst eine Ausgangsstufe, die das durch den Vorverstärker (1211) vorverstärkte Audiosignal verstärkt, sowie einen Eingang zur Stromversorgung des Nachstufenmoduls (122); ein Eingang des Boost-Moduls (11) ist mit einer Stromversorgung verbunden, um ein erstes Spannungssignal von der Stromversorgung zu erhalten, ein Ausgang des Boost-Moduls (11) ist mit dem Eingang des Vorstufenmoduls (121) verbunden und der Eingang des Nachstufenmoduls (122) ist mit der Stromversorgung verbunden, um das erste Spannungssignal von der Stromversorgung zu erhalten; und
das Boost-Modul (11) ist so konfiguriert, dass es das erste Spannungssignal hochsetzt, wenn der Spannungswert des ersten Spannungssignals kleiner als ein erster vorgegebener Spannungswert ist, um ein zweites Spannungssignal zu erhalten, dessen Spannungswert ein zweiter vorgegebener Spannungswert ist, und das zweite Spannungssignal an den Eingang des Vorstufenmoduls (121) überträgt, wobei der zweite vorgegebene Spannungswert nicht kleiner als der erste vorgegebene Spannungswert ist; und
das Spannungsbestimmungsmodul (13) ist so konfiguriert, dass es den Spannungswert des ersten Spannungssignals erkennt und eine Rücksetz-Anweisung an den Controller (1212) sendet, wenn der Spannungswert des ersten Spannungssignals kleiner als ein dritter vorgegebener Spannungswert ist, wobei der dritte vorgegebene Spannungswert kleiner als der erste vorgegebene Spannungswert ist; und
der Controller (1212), der so konfiguriert ist, den Audioverstärker (12) zurückzusetzen, wenn die Rücksetz-Anweisung empfangen wird.

2. Schaltung nach Anspruch 1, wobei das Boost-Modul (11) ein System Boost ist und das System Boost ein natives Boost-Modul auf einer Leiterplatte ist, auf der sich der Audioverstärker (12) befindet.

3. Schaltung nach Anspruch 1, wobei das Boost-Modul (11) ein zweiter Boost ist.

4. Schaltung nach Anspruch 1, wobei das Boost-Modul (11) ein Boost Bypass ist.

5. Schaltung nach Anspruch 1 bis 4, wobei das Spannungsbestimmungsmodul (13) Folgendes umfasst:
ein Spannungserfassungssubmodul (131) und ein System-on-Chip (132), wobei
das Spannungserfassungssubmodul (131) jeweils mit der Stromversorgung und dem System-on-Chip (132) verbunden ist und das System-on-Chip (132) mit dem Controller (1212) verbunden ist;
Das Spannungsmessuntermodul (131) ist konfiguriert, den Spannungswert des ersten Spannungssignals zu erfassen und den Spannungswert des ersten Spannungssignals an das System-on-Chip (132) zu senden; und
Das System-on-Chip (132) ist dazu konfiguriert, den Spannungswert des ersten Spannungssignals mit dem dritten voreingestellten Spannungswert zu vergleichen und die Rücksetz-Anweisung an den Controller (1212) zu senden, wenn der empfangene Spannungswert des ersten Spannungssignals kleiner ist als der dritte voreingestellte Spannungswert.

6. Schaltung nach Anspruch 5, wobei das Spannungsmessuntermodul (131) eine Energiemanagementeinheit oder ein Voltmeter ist, und sowohl das Spannungsmessuntermodul (131) als auch das System-on-Chip (132) sind native Geräte auf einer Leiterplatte, auf der sich der Audioverstärker (12) befindet.

7. Eine Leiterplatte, umfassend:
die Audioverstärkerschaltung (1) nach einem der Ansprüche 1 bis 6.

8. Ein elektronisches Gerät, umfassend:
die Leiterplatte nach Anspruch 7.

## Revendications

1. Circuit d'amplification audio (1), comprenant :
un module d'augmentation (11), un amplificateur audio (12) et un module de détermination de tension (13), l'amplificateur audio (12) comprenant un pré-module (121) et un post-module (122) ; le pré-module (121) comprend un préamplificateur (1211) configuré pour pré-amplifier un signal audio, un contrôleur (1212) et une entrée d'alimentation du pré-module (121), et le post-module (122) comprend un étage de sortie configuré pour amplifier le signal audio pré-amplifié par le préamplificateur (1211) et une entrée d'alimentation pour alimenter le post-module (122) ; une entrée du module d'augmentation (11) est connectée à une alimentation afin de recevoir un premier signal de tension de l'alimentation, une sortie du module d'augmentation (11) est connectée à l'entrée du pré-module (121), et l'entrée du post-module (122) est connectée à l'alimentation pour recevoir le premier signal de tension de l'alimentation ; et
le module d'augmentation (11) est configuré pour augmenter le premier signal de tension lorsque la valeur de tension du premier signal de tension est inférieure à une première valeur de tension prédéfinie, afin d'obtenir un second signal de tension dont la valeur de tension est une seconde valeur de tension prédéfinie, et d'envoyer le second signal de tension à l'entrée du pré-module (121), la seconde valeur de tension prédéfinie n'étant pas inférieure à la première valeur de tension prédéfinie ; et
le module de détermination de tension (13) est configuré pour détecter la valeur de tension du premier signal de tension et envoyer une instruction de réinitialisation au contrôleur (1212) lorsque la valeur de tension du premier signal de tension est inférieure à une troisième valeur de tension prédéfinie, la troisième valeur de tension prédéfinie étant inférieure à la première valeur de tension prédéfinie ; et
le contrôleur (1212), configuré pour réinitialiser l'amplificateur audio (12) en réponse à la réception de l'instruction de réinitialisation.

2. Circuit selon la revendication 1, dans lequel le module d'augmentation (11) est un System Boost, et le System Boost est un module d'augmentation natif d'une carte sur laquelle l'amplificateur audio (12) est situé.

3. Circuit selon la revendication 1, dans lequel le module d'augmentation (11) est un second Boost.

4. Circuit selon la revendication 1, dans lequel le module d'augmentation (11) est un Boost Bypass.

5. Circuit selon les revendications 1 à 4, dans lequel le module de détermination de tension (13) comprend :
un sous-module de mesure de tension (131) et un système sur puce (132), où
le sous-module de mesure de tension (131) est respectivement connecté à l'alimentation et au système sur puce (132), et le système sur puce (132) est connecté au contrôleur (1212) ;
le sous-module de mesure de tension (131) est conçu pour détecter la valeur de tension du premier signal de tension, et envoyer la valeur de tension du premier signal de tension au système sur puce (132) ; et
le système sur puce (132) est conçu pour comparer la valeur de tension du premier signal de tension avec la troisième valeur de tension prédéfinie, et envoyer l'instruction de réinitialisation au contrôleur (1212) lorsque la valeur de tension reçue du premier signal de tension est inférieure à la troisième valeur de tension prédéfinie.

6. Le circuit selon la revendication 5, dans lequel le sous-module de mesure de tension (131) est une unité de gestion d'alimentation ou un voltmètre, et à la fois le sous-module de mesure de tension (131) et le système sur puce (132) sont des dispositifs natifs sur une carte sur laquelle l'amplificateur audio (12) est situé.

7. Une carte, comprenant :
le circuit d'amplification audio (1) selon l'une quelconque des revendications 1 à 6.

8. Un dispositif électronique, comprenant :
la carte selon la revendication 7.
